# EUROPEAN PATENT APPLICATION

(11) **EP 4 783 220 A2**
(43) Date of publication of application: **29.07.2026**
(21) Application number: 26152919.2
(22) Date of filing: 20.01.2026
(51) Int. Cl.: H01J 33/02, H01J 1/18, B65B 55/08, H01K 1/24, H01J 37/065, B65B 9/20

(54) **ELECTRON BEAM EMITTING DEVICE FOR STERILIZING A WEB OF PACKAGING MATERIAL**

(30) Priority: 27.01.2025 EP 25154054
(71) Applicant: Tetra Laval Holdings & Finance S.A., 1009 Pully (CH)
(72) Inventor: GEBOLIS, Piotr, 3175 Wünnewil-Flamatt (CH)
(74) Representative: Tetra Pak Patent Attorneys

(57) **Abstract**

There is described an electron beam emitting device (11) configured to sterilize a packaging material (4) for the production of packages (2) containing a pourable product, the emitting device (11) comprises: a generation chamber (14); an elongated generation member (15) arranged within the generation chamber (14), extending along a longitudinal axis (A) and configured to be supplied with electrical energy from a power supply source (100) and to convert the electrical energy into an electron beam; an electric connector (20) coupled to an axial end portion (15b) of the generation member (15) and configured for transferring electrical energy between the power supply source (100) and the generation member (15); the electric connector (20) comprises a main body (21) made of electrically conductive material, extending around said axial end portion (15b) and having a symmetrical configuration with respect to the longitudinal axis (A) and/or with respect to the axial end portion (15b).

## Description

### TECHNICAL FIELD

The present invention relates to an electron beam emitting device configured to sterilize a web of packaging material for the production of packages containing a pourable product, preferably a pourable food product.

### BACKGROUND ART

As it is generally known, many pourable food products, such as fruit juice, UHT (ultra-high temperature-treated) milk, wine, tomato sauce, etc., are sold in packages made of sterilized packaging material.

A typical example is the parallelepiped-shaped package for pourable food products known as Tetra Brik Aseptic (registered trademark), which is made by folding and sealing a laminated web of packaging material.

The packaging material has a multilayer structure comprising a base layer, e.g. made of paper, covered on both sides with layers of heat-sealable material, e.g. polyethylene.

In the case of aseptic packages for long-storage products, such as UHT milk, the packaging material also comprises a layer of oxygen-barrier material, e.g. an aluminum foil, which is superimposed on a layer of heat-sealable material, and is in turn covered with another layer of heat-sealable material forming the inner face of the package eventually contacting the food product.

Packages of this sort are normally produced on fully automatic packaging machines, which form and fill the packages starting from a multilayer web of packaging material.

In particular, according to a non-limiting example of a packaging machine, a continuous tube is formed from the web of packaging material which is initially wound in a reel and fed through a plurality of unwinding rollers.

The web of packaging material is typically maintained in a closed, sterile environment, and, while advanced by the aforementioned unwinding rollers, is folded to form the tube by means of a known web folding unit and then sealed longitudinally.

In order to perform the package forming operations, the tube is continuously fed along a straight vertical direction, is filled with the sterilized food product from above and is formed, sealed and subsequently cut along equally spaced transversal cross-sections extending along a direction orthogonal to the vertical direction, according to a manner known and not described in detail.

So-called pillow packs are obtained thereby, which have a longitudinal sealing band, a top transversal sealing band and a bottom transversal sealing band. The pillow packs are then cut at the cross-sections to be separated from one another and directed to a folding unit of the packaging machine for the final folding thereof.

The finished packages are thereby obtained.

It is known in the field the need for sterilizing the web of packaging material before the forming and filling operations, with the aim to extend the shelf-life of the products being packed.

According to a known solution, the advancing web is irradiated with an electron beam emitted by an electron beam emitting device located at a sterilization station.

A typical electron beam emitting device includes a beam generation member, usually defined by a tungsten filament, which is connected to a power supply. Being supplied with electrical energy, the generation filament undergoes a so-called thermionic emission whereby starts to emit electrons.

The emitting device also includes two electrode members, that is a cathode member and an anode member.

The electrode members are configured to focus the generated electrons (i.e. the electrons emitted by the filament) into a beam.

In detail, the emitting device comprises a bent metal sheet extending along a longitudinal axis, normally having a U-shaped cross section, and therefore defining a sort of tubular body open upwards.

In greater detail, the bent sheet includes an upper aperture extending axially, thereby defining the U-shaped cross section.

The generation filament is arranged within the bent sheet and extends in the axial direction. In particular, the bent sheet partially surrounds the generation filament, so as to protect it, and so as to deviate the generated electrons towards the upper aperture.

Accordingly, the bent sheet defines the cathode member and therefore is electrically charged (negatively). In this way, the electrons emitted by the filament interact with the electric field defined by the bent sheet / cathode member, and are deviated towards the upper aperture.

The emitting device further includes an outer casing defined by a tubular body extending along the longitudinal axis and surrounding the bent sheet.

The outer casing includes an elongated opening extending axially and facing, on one side, the sterilization station, and, on the other side, the upper aperture of the bent sheet. The elongated opening defines an exit window for the electron beams.

The anode member is arranged at the exit window, in order to attract the electrons thereat.

Accordingly, the anode member is electrically charged (positively).

In the known configurations, the generation filament is supported, at each one of the two opposite axial end portions thereof, by a support pin. In turn, each support pin is carried by a respective support element.

In order to supply the generation filament with the needed electric current, the generation filament is electrically connected with an electric circuit connected, in turn, with the aforementioned power supply.

In detail, according to the known configurations, an input wire of the circuit is directly connected to one support pin, whereas an output wire is directly connected to the other support pin.

Expediently, the support pins are made of an electrically conductive material.

As it is known, during use, the emitting device is subjected to high temperatures.

Specifically, the generation tungsten filament reaches, in use, temperatures of up to 2000°C, at which the thermionic emission is established.

Hence, the generation filament, as well as other components of the emitting device, undergoes thermal deformation, especially along the axial direction.

A need is felt for the generation filament to maintain as much as possible its linear configuration along the longitudinal axis. A need is felt to avoid an undesired bending or however deformation of the filament.

Hence, the Applicant has observed that the electron beam emitting devices of the aforementioned type are still open for further improvement, in particular as per generally improving the electron beam emission, which in some cases may be influenced by the aforementioned thermal expansion.

### DISCLOSURE OF INVENTION

It is therefore an object of the present invention to provide an electron beam emitting device which is designed to meet the above-mentioned need in a straightforward and low-cost manner.

This object is achieved by an electron beam emitting device as claimed in the appended independent claim 1. Preferred embodiments of the present invention are laid down in the appended dependent claims.

### BRIEF DESCRIPTION OF THE DRAWINGS

A non-limiting embodiment of the present invention will be described by way of example with reference to the accompanying drawings, in which:
Figure 1 is a schematic perspective view, with parts removed for clarity, of a packaging machine comprising an electron beam emitting device according to the present invention;
Figure 2 is a larger-scale perspective view, with parts removed for clarity, of the electron beam emitting device according to the present invention;
Figure 3 is a larger-scale perspective view, with parts removed for clarity, of an electric connector of the emitting device;
Figures 4a and 4b are larger-scale top view, with parts removed for clarity, of the electric connector during two distinct operative conditions;
Figure 5 is a larger-scale perspective view, with parts removed for clarity, of part of the electric connector.

### BEST MODE FOR CARRYING OUT THE INVENTION

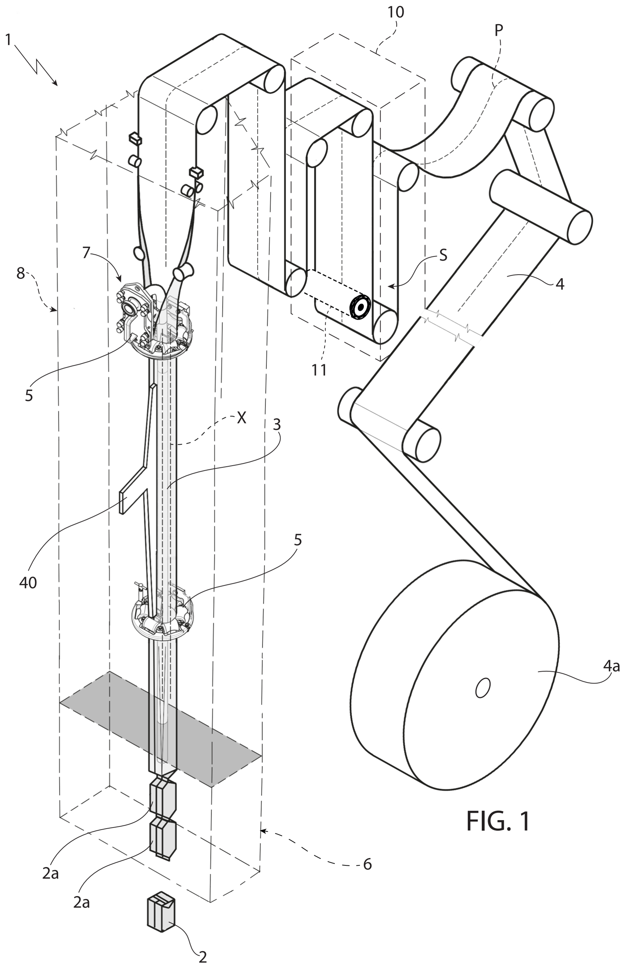

With reference to Figure 1, number 1 indicates as a whole a non-limiting example of a packaging machine configured to produce sealed packages 2 containing a pourable product, preferably a pourable food product such as pasteurized or UHT milk, water, fruit juice, wine, peas, beans, etc. The present invention will refer to an electron beam emitting device for the use in such a packaging machine 1, without however losing on generality. In fact, the electron beam emitting device as described hereinafter may be used in other apparatuses or machines different from packaging machine 1, which is hereby described as a mere example of application for the emitting device.

Packaging machine 1 is configured to form, seal and fold packages 2 starting from a web 4 of packaging material, which is initially wound in a reel 4a, and then folded into a tube 3 of packaging material.

As shown in Figure 1, packaging machine 1 comprises:
- conveying means configured to advance web 4 along an advancement path P;
- a tube folding device 5 configured to progressively fold web 4 into a tube 3;
- a sealing element 40 for longitudinally seal tube 3, in a manner known and not described in detail;
- a filling device 7 for filling tube 3 (from above) with the pourable product;
- a forming and sealing unit 6 configured to form tube 3 and seal tube 3 along successive transversal cross-sections thereof in order to obtain a sequence of pillow packs 2a, in a manner known and not described in detail;
- an isolation chamber 8 internally defining an environment containing a controlled atmosphere, in particular sterile and/or aseptic gas, preferably sterile and/or aseptic air, and housing at least the forming and sealing unit 6, the tube folding device 5, the sealing element 40 and at least part of the filling device 7;
- a folding device (not shown) configured to sequentially fold packs 2a in order to obtain a plurality of sealed packages 2.

Tube folding device 5 and sealing element 40 define together a tube forming unit.

Preferably, forming and sealing unit 6 has an axis X along which tube 3 is fed, in use.

Axis X is parallel to a straight direction, which preferably is a straight vertical direction.

Hence, in use, tube 3 is fed along axis X, downwards, and while being filled from above is formed and sealed by forming and sealing unit 6.

More specifically, tube 3 is drawn (downwards) along axis X by forming and sealing unit 6 in a known manner.

In this way, a plurality of pillow packs 2a are obtained.

In light of the above, packaging machine 1 is configured to form and seal a plurality of pillow packs 2a containing the pourable product starting from web 4 and tube 3 and then to fold the pillow packs 2a for obtaining the aforementioned formed, sealed and folded packages 2 containing the pourable product.

As schematized in Figure 1, packaging machine 1 further comprises a sterilization unit 10 arranged at a sterilization station S along advancement path P, in a position upstream of tube folding device 5 and configured to perform a sterilizing treatment on web 4.

In particular, sterilization unit 10 is configured to sterilize web 4 by means of electron beam irradiation.

To this end, sterilization unit 10 comprises at least one electron beam emitting device 11.

Preferably, sterilization unit 10 comprises a pair of emitting devices 11 (only one shown in Figure 1), arranged at opposite sides of web 4 at sterilization station S, for irradiating web 4 from both sides in order to obtain the desired level of sterilization.

In light of the above, each emitting device 11 is configured to sterilize the packaging material for the production of packages 2.

The web 4 crossing, in use, sterilization station S defines, thus, a target to be sterilized by the emitting devices 11.

Reference will be made in the following to a single emitting device 11. However, the structural and functional features described therefor are equally applicable to the other emitting device 11.

Emitting device has a support flange 12 which defines a fixed frame of the emitting device 11 itself.

In detail, support flange 12 is adapted to be coupled to a fixed frame of packaging machine 1 and/or to a power supply source 100, i.e. an electric current generator.

Opportunely, emitting device 11 has an inner casing 13 internally defining a generation chamber 14, preferably controlled in vacuum conditions.

In particular, inner casing 13 is made of electrically conductive material, such as stainless steel, and is defined by a tubular body mounted, in particular rigidly mounted, more in particular welded, to the support flange 12.

Emitting device 11 comprises an elongated generation member 15 arranged within the chamber 14, extending along a longitudinal axis A, and configured to be supplied with electrical energy from said power supply source 100 and to convert the electrical energy into emitted electrons.

In particular, emitting device 11 includes an electron beam generation circuit (known per se and not described in detail), and generation member 15 is part of such generation circuit.

In detail, generation member 15 comprises a filament 15a of electrically conductive material.

In greater detail, generation member 15 comprises a filament 15a of tungsten.

Filament 15a extends along axis A and is configured to heat up and emit electrons when supplied with electrical energy.

More specifically, filament 15a is supplied, in use, with electrical energy (from the aforementioned power source) and heats up due to Joule effect. When filament 15a reaches a predetermined temperature, a so-called thermionic emission establishes. Thermionic emission is the liberation of charged particles from a hot electrode whose thermal energy gives some particles enough kinetic energy to escape the electrode surface.

Generation member 15 further comprises two support pins 15b (only one shown) coupled to the filament 15a at opposite axial ends thereof and made of electrically conductive material. Each support pin 15b defines an axial end portion of the generation member 15.

In the following, both support pins and axial end portions may be indicated with reference number 15b.

Inner casing 13 extends along the axial direction.

Inner casing 13 has an elongated slit 16 extending axially and configured for allowing the exit of the generated electrons from the tubular body.

In particular, slit 16 defines an aperture obtained on the outer surface of inner casing 13, which allows chamber 14 to open outwards.

In light of the above, inner casing 13 extends around generation member 15 (and in particular filament 15a), with the exception of its portion provided with slit 16.

Emitting device 11 has a cathode member and an anode member configured to be electrically charged with opposite electric charge, respectively, for focusing the (generated) electron beam towards a target to be sterilized, e.g. towards the web 4 passing through sterilization station S, according to a manner known and not described in detail herein.

Inner casing 13 defines the cathode member of the emitting device 11.

Hence, inner casing 13 is electrically charged, with a negative electric charge.

In this way, in use, the electrons emitted by the generation member 15 are deflected towards slit 16.

Conveniently, emitting device 11 further comprises a grid element 17 which is arranged to cover slit 16.

Grid element 17 is configured to be electrically charged so as to attract the generated electrons, thereby directioning the electrons to exit generation chamber 14.

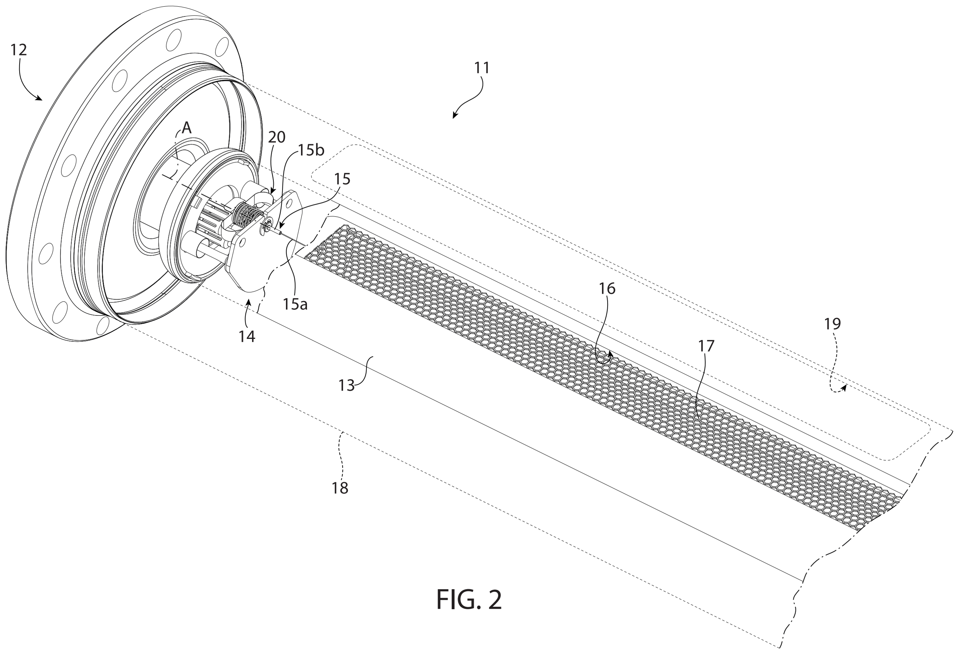

Conveniently, emitting device 11 further comprises an outer casing 18 which is defined by a further tubular body mounted, in particular rigidly mounted, more in particular welded, to support flange 12 (Figure 2). Outer casing 18 extends along the axial direction. Outer casing 18 surrounds inner casing 13.

In detail, inner casing 13 is arranged within outer casing 18.

Outer casing 18 includes an elongated opening 19 which extends axially and is aligned with slit 16.

In particular, opening 19 defines an aperture obtained on the outer surface of outer casing 18, and is aligned with slit 16 along a radial direction, with respect to axis A.

In practice, opening 19 is superimposed on slit 16, along the radial direction, as shown in Figure 2.

Opening 19 defines an exit gate for allowing the (generated) electrons to exit from emitting device 11.

Expediently, the anode member (known per se and not described in detail) is arranged at opening 19 and is configured for attracting the electrons thereat.

Accordingly, the anode member is arranged between the generation member 15 and the sterilization station S. For example, the generated electron beam is directed and focused towards sterilization station S, and thus towards the web 4 to be sterilized.

Emitting device 11 further comprises an electric connector 20 coupled to one axial end portion 15b of the generation member 15 and configured for transferring electrical energy between the power supply source 100 and the generation member 15.

In detail, emitting device 11 comprises two electric connectors 20, each arranged at one respective axial end portion of the generation member 15, and in particular at said support pin 15b.

The electric connectors 20 are part of the aforementioned generation circuit.

More specifically, one electric connector 20 is arranged between the power supply source 100 and the generation member 15, and the other electric connector 20 is arranged between the generation member 15 and a return branch of the generation circuit.

Reference will be made in the following to a single electric connector 20, in particular to the one arranged between the power supply source 100 and the generation member 15.

However, the features described hereinafter are equally applicable to the other electric connector 20.

According to an aspect of the present invention, electric connector 20 comprises a main body 21 made of electrically conductive material, extending around the axial end portion 15b and having a symmetrical configuration with respect to axis A and/or with respect to the axial end portion 15b. The main body 21 may be elastically deformable along axis A.

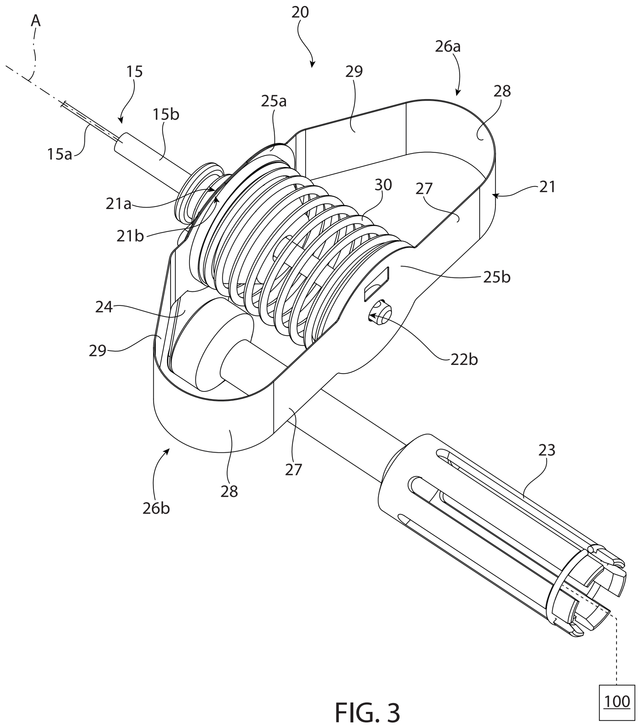

In detail, main body 21 is coupled to the respective support pin 15b, extends around the support pin 15b and has a symmetric configuration with respect to the support pin 15b, as shown in Figures 3, 4a-4b, and 5.

In greater detail, main body 21 comprises a pair of through holes 22a, 22b arranged along axis A and engaged by axial end portion 15b, thereby defining respective support seats for the generation member 15.

Accordingly, electric connector 20 is configured to transfer electrical energy via such support seats.

More specifically, with reference to Figure 3, emitting device 11 includes a power supply inlet 23 configured to be connected (in use) to the power supply source 100.

Main body 21 is electrically connected to the power supply inlet 23 via a connection element, preferably a connection plate 24 made of electrically conductive material.

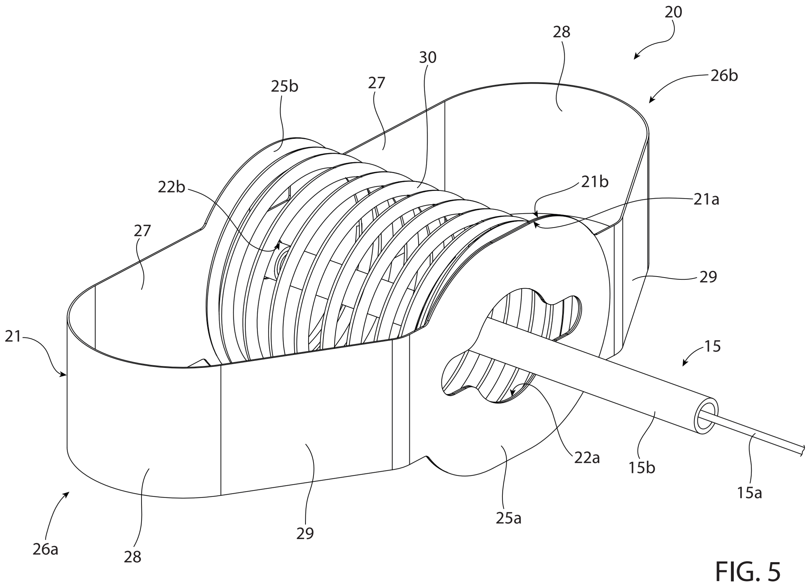

The support pin 15b engages with contact at least one of the through holes 22a, 22b (Figure 5). In this way, the electric connection between the inlet 23 and the filament 15a is established.

According to the invention, the main body 21 is defined by a closed-loop endless strip of electrically conductive material.

Alternatively, as shown, the main body 21 is defined by a strip of electrically conductive material having two free ends 21a, 21b and bent so that the two free ends 21a, 21b thereof overlap on top of one another, so as to define a closed-loop endless strip of material.

In the following, both main body and endless strip may be indicated with the same reference number 21.

In particular, main body, that is endless strip, 21 has a first portion 25a and a second portion 25b.

The first portion 25a and the second portion 25b are arranged along axis A and face along the axial direction.

More precisely, first portion 25a and second portion 25b define respective axial walls or surfaces which are arranged along axis A and face one another along axis A.

A first through hole 22a of said pair is arranged at first portion 25a, whereas a second through hole 22b of said pair is arranged at second portion 25b.

As visible in Figures 3 to 5, second portion 25b is located closer to a free end of axial end portion 15b than the first portion 25a.

According to a preferred advantageous embodiment of the present invention, main body 21 comprises a first curved wing 26a extending radially with respect to axis A and extending from the first portion 25a to the second portion 25b, and a second curved wing 26b extending radially with respect to axis A and extending from the first portion 25a to the second portion 25b.

According to the invention, the first wing 26a and the second wing 26b are symmetrical with respect to axis A and/or to axial end portion 15b, and define, together with the first portion 25a and the second portion 25b, said endless strip 21.

In other words, first wing 26a and second wing 26b define symmetrical portions of endless strip 21.

In detail, each one of the first wing 26a and the second wing 26b includes a first linear stretch 27, which extends radially from the longitudinal axis A, a second linear stretch 29, which extends radially from the longitudinal axis A at an axial distance from the first linear stretch 27, and a curved stretch 28, which is bent and connects the first linear stretch 27 and the second linear stretch 29.

In greater detail, each one of the first wing 26a and second wing 26b includes a first linear stretch 27, which extends radially from one of the first portion 25a or second portion 25b, a second curved stretch 28, which extends from the first stretch 27 and is bent towards the other of the first portion 25a and second portion 25b, and a third linear stretch 29, which extends from the second stretch 28 and up to said other of the first portion 25a and second portion 25b.

Conveniently, the first linear stretch 27 extends from the second portion 25b, and the third linear stretch 29 extends from the first portion 25a and is inclined towards the first linear stretch 27 with respect to the axial direction.

In other words, the first linear stretch 27 is substantially perpendicular with respect to the longitudinal axis A and the third linear stretch 29 is inclined with respect to the first linear stretch 27, in such a way that an end of the third linear stretch 29 away from the longitudinal axis A is closer to the first linear stretch 27 with respect to an end of the third linear stretch 29 closer to the longitudinal axis A.

In light of the above, and referring to the appended figures 3 to 5, endless strip, i.e. main body, 21 has a substantially trapezoidal shape, in particular with rounded vertexes.

More specifically, first portion 25a is arranged at the minor base of the trapezoidal shape and the second portion 25b is arranged at the major base of the trapezoidal shape.

Accordingly, thanks to the aforementioned configuration and design, endless strip 21 defines an elastic body configured to elastically retain its configuration and shape after a certain deformation within a deformation threshold.

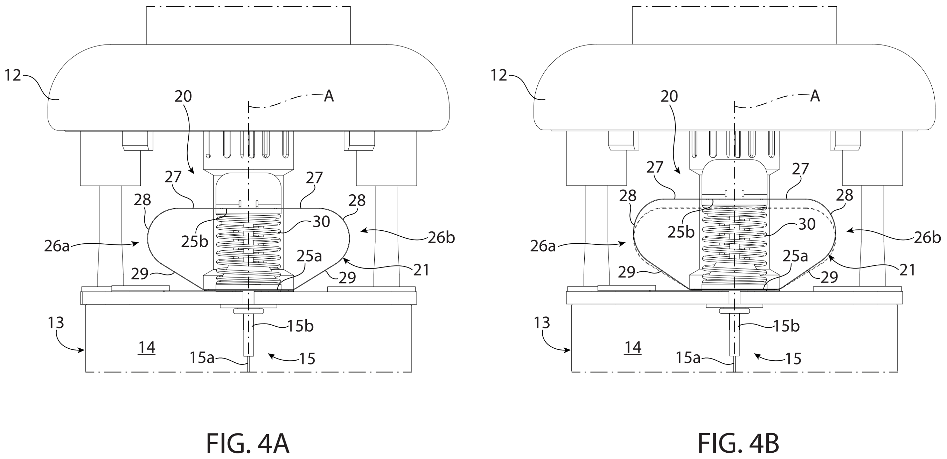

More specifically, figure 4a shows the electric connector 20 in a rest (i.e. non-operative) condition, in which no electric energy is supplied to generation member 15.

In this condition, filament 15a in undeformed and also main body 21 is undeformed.

Figure 4b shows the electric connector 20 in an operative condition, whereby electric energy is supplied to the generation member 15, thereby causing the heating of the filament 15a and the consequent thermal expansion (mainly along axis A) thereof.

Due to the thermal expansion, the generation member 15 deforms (expands) axially.

Therefore, also the main body 21, being elastic due to its peculiar configuration and design, deforms, as shown in Figure 4b.

The original shape at rest of the main body 21 is shown in Figure 4b in dashed line.

Thanks to the design of the electric connector 20, and in particular thanks to the symmetric configuration thereof and to the peculiar shape thereof, the Applicant has observed that the linearity and coaxiality of filament 15a in the deformed state with respect to its undeformed rest state is substantially maintained.

In fact, the symmetric configuration and the peculiar shape of main body 21 support and guide, at the same time, filament 15a during its thermal expansion, following its movement. Thereby, the risk of bending of filament 15a with respect to the axial direction is significantly reduced.

As a result, the electron beam emission is generally improved, hence the sterilization of web 4 is improved.

Advantageously, main body 21 is made in one single piece. That is, the main body 21 has a continuous, uninterrupted structure with no bonded, welded, or fastened components. It is manufactured as a unitary element, ensuring structural integrity without the need for assembly or joining multiple parts.

The Applicant has noted that such single piece configuration results in an improved elasticity and resilience, especially in view of the fact that the main body 21 undergoes deformations due to the thermal loads which it is subjected to in operation, as explained above.

Advantageously, main body 21 is made of an alloy comprising copper (Cu) and beryllium (Be).

The Applicant has observed that such alloy represents the optimal compromise between the needed electric conductivity and the desired elasticity of the material.

Advantageously, electric connector 20 further comprises a spring member 30 located between the first portion 25a and the second portion 25b.

Preferably, spring member 30 is an helicoidal spring.

More preferably, spring member 30 has a constant pitch.

Spring member 30 has a central axis coaxial to axis A.

As visible in particular in Figure 3, 4a and 4b, the first portion 25a and the second portion 25b define respective axial abutment surfaces for opposite axial ends of the spring member 30.

Conveniently, spring member 30 is preloaded between the first portion 25a and the second portion 25b.

Precisely, the spring member 30 is configured to bias the respective axial end portion 15b of the generation member 15 towards the opposite axial end portion 15b thereof.

More precisely, the spring members 30 of the two electric connectors 20 are configured to bias the respective axial end portions 15b of the generation member 15 towards one another.

In other words, spring member 30 axially tractions when generation member 15 expands, due to the operative thermal loads applied thereto in use, and tends to compress due to its elastic return force. More specifically, spring member 30 is compressed in its steady-state, whereas in operation spring member 30 extends (axially).

In this way, spring member 30 further contributes to control the deformation of generation member 15 and to maintain it in a desired range, thereby further improving the electron beam emission and, ultimately, the sterilization quality.

In the preferred embodiment shown, endless strip 21 is defined by a thin sheet of material folded on itself.

This configuration gives endless strip 21 the needed elasticity.

Advantageously, the endless strip 21 has a constant thickness relative to a cross-section thereof transversal to a length direction of the strip 21.

Conveniently, the endless strip 21 has a substantially rectangular-shaped cross-section transversal to a length direction of the strip.

The Applicant observed that this particular configuration results in the optimal compromise between stiffness, elasticity and acceptable electrical resistance (which is given by the above mentioned cross-section) of electric connector 20.

The advantages of emitting device 11 according to the present invention will be clear from the foregoing description.

In particular, thanks to the design of the electric connector 20 according to the present disclosure, and in particular thanks to the symmetric configuration thereof and to the peculiar shape thereof, the Applicant has observed that the linearity and coaxiality of filament 15a in the deformed state with respect to its undeformed rest state is substantially maintained.

Thereby, the risk of bending of filament 15a with respect to the axial direction is significantly reduced.

As a result, the electron beam emission is generally improved, hence the sterilization of web 4 is improved.

Clearly, changes may be made to emitting device 11 as described herein without, however, departing from the scope of protection as defined in the accompanying claims.

## Claims

1. Electron beam emitting device (11), comprising:
- a generation chamber (14);
- an elongated generation member (15) arranged within the generation chamber (14), extending along a longitudinal axis (A) and configured to emit electrons as a result of electrical energy being supplied thereto;
- an electric connector (20) coupled to an axial end portion (15b) of the generation member (15) and configured for transferring electrical energy between the power supply source (100) and the generation member (15);
wherein the electric connector (20) comprises a main body (21) made of electrically conductive material, extending at least partially around said axial end portion (15b) and having a symmetrical configuration with respect to the longitudinal axis (A) and/or with respect to the axial end portion (15b).

2. Electron beam emitting device (11) as claimed in claim 1, wherein the main body (21) is made of an alloy comprising copper and beryllium.

3. Electron beam emitting device (11) as claimed in any one of the foregoing claims, wherein the main body (21) is made in one single piece.

4. Electron beam emitting device (11) as claimed in any one of the foregoing claims, wherein the main body (21) comprises a pair of through holes (22a, 22b) arranged along the longitudinal axis (A) and engaged by said axial end portion (15b) of the generation member (15), thereby defining respective support seats for the generation member (15).

5. Electron beam emitting device (11) as claimed in any one of the foregoing claims, wherein the main body (21) is defined by:
- a closed-loop endless strip (21) of electrically conductive material, or
- a strip of electrically conductive material having two free ends (21a, 21b) and bent so that the two free ends (21a, 21b) thereof overlap on top of one another, so as to define a closed-loop endless strip (21) of material.

6. Electron beam emitting device (11) as claimed in claims 4 and 5, wherein a first through hole (22a) of said pair is located at a first portion (25a) of said endless strip (21), and a second through hole (22b) of said pair is located at a second portion (25b) of said endless strip (21), the first portion (25a) and the second portion (25b) being arranged along the longitudinal axis (A) thereby facing along the axial direction.

7. Electron beam emitting device (11) as claimed in the preceding claim, wherein the electric connector (20) further comprises a spring member (30) located between the first portion (25a) and the second portion (25b) and having a central axis coaxial to the longitudinal axis (A), the first portion (25a) and the second portion (25b) defining respective axial abutment surfaces for opposite axial ends of the spring member (30), the spring member (30) being configured to bias the respective axial end portion (15b) of the generation member (15) towards the opposite axial end portion thereof.

8. Electron beam emitting device (11) as claimed in any of the previous claims, wherein the main body (21) includes symmetrical portions (26a, 26b) which are symmetrical with respect to the longitudinal axis (A) and/or with respect to the axial end portion (15b), and wherein the electric connector (20) further comprises a spring member (30) having a central axis coaxial to the longitudinal axis (A), the spring member (30) being positioned between the symmetrical portions (26a, 26b) of the main body (21), with respect to a direction transversal to the longitudinal axis (A).

9. Electron beam emitting device (11) as claimed in any of the previous claims, wherein the main body (21) comprises a first curved wing (26a) extending radially with respect to the longitudinal axis (A), and a second curved wing (26b) extending radially with respect to the longitudinal axis (A);
the first wing (26a) and the second wing (26b) being symmetrical with respect to the longitudinal axis (A) and/or with respect to said axial end portion (15b).

10. Electron beam emitting device (11) as claimed in the preceding claim, wherein each one of the first wing (26a) and the second wing (26b) includes a first linear stretch (27), which extends radially from the longitudinal axis (A), a second linear stretch (29), which extends radially from the longitudinal axis (A) at an axial distance from the first linear stretch (27), and a curved stretch (28), which is bent and connects the first linear stretch (27) and the second linear stretch (29).

11. Electron beam emitting device as claimed in the preceding claim, wherein the first linear stretch (27) is substantially perpendicular with respect to the longitudinal axis (A) and the third linear stretch (29) is inclined with respect to the first linear stretch (27), preferably an end of the third linear stretch (29) away from the longitudinal axis (A) is closer to the first linear stretch (27) with respect to an end of the third linear stretch (29) closer to the longitudinal axis (A).

12. Electron beam emitting device (11) as claimed in claim 6, wherein the main body (21) comprises a first curved wing (26a) extending radially with respect to the longitudinal axis (A) and extending from the first portion (25a) to the second portion (25b), and a second curved wing (26b) extending radially with respect to the longitudinal axis (A) and extending from the first portion (25a) to the second portion (25b);
the first wing (26a) and the second wing (26b) being symmetrical with respect to the longitudinal axis (A) and/or with respect to said axial end portion (15b), and defining, together with the first portion (25a) and the second portion (25b), said endless strip (21).

13. Electron beam emitting device (11) as claimed in any of the previous claims, wherein the main body (21) has a substantially trapezoidal shape, extending symmetrically with respect to the longitudinal axis (A).

14. Electron beam emitting device (11) as claimed in any of the previous claims, wherein the main body (21) defines an elastic body configured to elastically retain its configuration and shape after a certain deformation within a deformation threshold.

15. Electron beam emitting device (11) as claimed in any one of the previous claims, wherein the main body (21) has a constant thickness, relative to a cross-section thereof transversal to a length direction of the main body (21).

16. Packaging machine (1) configured for producing packages (2) containing a pourable product starting from a web (4) of packaging material, the packaging machine (1) comprising:
- conveying means configured to advance the web (4) along an advancement path (P);
- a tube forming unit (5, 40) configured to fold the web (4) into a tube (3) and to longitudinally seal the tube (3);
- a forming and sealing unit (6) configured to form the tube (3) and seal the tube (3) along successive transversal cross-sections thereof in order to obtain a sequence of packs (2a);
- a folding device configured to sequentially fold the packs (2a) in order to obtain a plurality of sealed packages (2); and
- a sterilization unit (10) arranged along the advancement path (P) upstream of the tube forming unit (5, 40) and configured to sterilize the web;
wherein the sterilization unit (10) comprises at least one electron beam emitting device (11) as claimed in any one of the foregoing claims.
